# EUROPEAN PATENT APPLICATION

(11) **EP 2 543 754 A1**
(43) Date of publication of application: **09.01.2013**
(21) Application number: 11750629.5
(22) Date of filing: 01.03.2011
(51) Int. Cl.: C30B 29/40, C23C 16/30, C30B 25/18, H01L 21/205

(54) **SEMICONDUCTOR EPITAXIAL SUBSTRATE**

(30) Priority: 02.03.2010 JP 2010044819
(71) Applicant: JX Nippon Mining & Metals Corporation, Tokyo 100-8164 (JP)
(72) Inventor: KAKUTA, Koji, Toda-shi Saitama 335-8502 (JP); NOZAKI, Tatsuya, Toda-shi Saitama 335-8502 (JP); KANAI, Susumu, Toda-shi Saitama 335-8502 (JP)
(74) Representative: Jones, Helen M.M.
(86) International application number: PCT/JP2011/054581
(87) International publication number: WO 2011/108519

(57) **Abstract**

Provided is a semiconductor epitaxial substrate which has low semiconductor layer mosaicity and is suitable for the production of a semiconductor device. Specifically provided is a semiconductor epitaxial substrate formed by epitaxially growing a graded buffer layer which is compositionally graded such that the lattice constant increases in stages within a range from a first lattice constant to a second lattice constant larger than the first lattice constant, and a semiconductor layer produced from a semiconductor crystal having the second lattice constant on a semiconductor substrate having the first lattice constant. The angle formed by the (mnn) plane (m and n are integers except m=n=0) of the semiconductor layer and the (mnn) plane of the semiconductor substrate is set to +0.05° or more when the direction that rotates clockwise from the [100] direction to the [011] direction is positive.

## Description

### Field of the Invention

The present invention relates to a semiconductor epitaxial substrate having a semiconductor layer which has a lattice constant different from that of the growth substrate, and is epitaxially grown on a growth substrate while placing a graded buffer layer in between.

### Description of Related Art

A semiconductor epitaxial substrate configured by an InP substrate which is used as a growth substrate, and a photo-absorption layer which is composed of InGaAs crystal grown on the InP substrate and has the lattice constant (5.8688 Ǻ) equal to that of the InP substrate, has been used for infrared sensors having sensitivities up to 1.7 µm or around. This sort of semiconductor epitaxial substrate is manufactured, for example, by epitaxial growth process such as metal organic chemical vapor deposition (MOCVD) and hydride vapor phase epitaxy (HVPE).

On the other hand, near-infrared sensors having sensitivities in longer wavelength ranges of approximately 1.9 to 2.6 µm need a photo-absorption layer composed of InGaAs which has a lattice constant larger than that of the InP substrate (5.87 to 6.00 Ǻ, for example) . When the semiconductor layer having the lattice constant different from that of the growth substrate is grown thereon as the photo-absorption layer, lattice defect such as misfit dislocation occurs at the interface between the growth substrate and the semiconductor layer, and the lattice defect also propagates into the semiconductor layer. A high density of lattice defect in the photo-absorption layer considerably degrades performances of the near-infrared sensor.
Accordingly, for the case where the InGaAs having the lattice constant larger than that of the InP substrate is used as the photo-absorption layer, one known technique is such as providing, between the InP substrate and the InGaAs photo-absorption layer, a graded buffer layer (such as InAsₓP₁₋ₓ (0≤x≤1)) having the lattice constant which increases stepwise from the lattice constant of the InP substrate to the lattice constant of the InGaAs photo-absorption layer, to thereby prevent the lattice defect from propagating towards the InGaAs photo-absorption layer (see Patent Documents 1 and 2, for example).
Another general method is such as growing the semiconductor layer epitaxially on an off-angle growth substrate which has an inclined (by 2 degrees, for example) principal surface (see Non-Patent Document 1, for example).

### Prior Art Documents

### Patent Documents

Patent Document 1: Japanese Examined Patent Publication No. 3285981
Patent Document 2: Japanese Laid-Open Patent Publication No. 2004-319765

### Non-Patent Document

Non-Patent Document 1: M.A. di Forte-Poisson et al., J. Cryst. Growth, 124 (1992), 782

### SUMMARY

### Problems to be Solved by the Invention

In the process of epitaxial growth of the semiconductor layer (InGaAs photo-absorption layer, for example) by MOCVD, a growth substrate generally used has the (100) surface. However, the graded buffer layer, which has the lattice constant larger than that of the growth substrate and is grown thereon, was found to have a lot of micro-domains formed in the grown crystal, each having direction of crystal axis slightly different from that of the growth substrate, to thereby give a mosaic structure composed of an assemblage of the micro-domains. Generation of such mosaic structure may result in increase in lattice defect in the crystal, and may degrade quality of the compound semiconductor crystal.

It is therefore an object of the present invention to provide a semiconductor epitaxial substrate having a semiconductor layer which has the lattice constant different from that of the growth substrate, epitaxially grown on the growth substrate while placing a graded buffer layer in between, featured by a small mosaicity of the semiconductor layer, and is suitable for manufacturing of semiconductor devices.

### Means for Solving the Problems

The invention described in Claim 1 is conceived in order to achieve the object described in the above. According to the invention, there is provided a semiconductor epitaxial substrate which includes:
a semiconductor substrate having a first lattice constant;
a graded buffer layer which is compositionally graded so as to increase the lattice constant stepwise in the range from the first lattice constant to a second lattice constant larger than the first lattice constant and epitaxially grown on the semiconductor substrate; and
a semiconductor layer which is composed of a semiconductor crystal having the second lattice constant and epitaxially grown on the graded buffer layer, wherein
the angle between the (mnn) plane (where, m and n are integers except m=n=0) of the semiconductor layer and the (mnn) plane of the semiconductor substrate is +0.05° or larger, when the clockwise direction of rotation from the [100] direction to the [011] direction is positive.

According to the invention described in Claim 2, there is provided the semiconductor epitaxial substrate of Claim 1, wherein
the semiconductor substrate is composed of InP;
the graded buffer layer is composed of InAsP; and
the semiconductor layer is composed of InGaAs.

### Effects of the Invention

According to the semiconductor epitaxial substrate of the present invention, since the semiconductor layer has a small mosaicity and has an extremely high crystallinity, so that performances of semiconductor devices such as infrared sensor may be improved to a considerable degree.

### BRIEF DESCRIPTION OF THE DRAWINGS

[FIG. 1] It is a drawing illustrating a multi-layered structure of a semiconductor epitaxial substrate according to one embodiment.
[FIG. 2] It is a drawing illustrating an angle of inclination α of the (5-1-1) plane of an InGaAs photo-absorption layer away from the (5-1-1) plane of an InP substrate 11, expressed in a reciprocal lattice space.
[FIG. 3] It is a drawing illustrating a reciprocal lattice map of a semiconductor epitaxial substrate 1 which has a 2° off-angle InP substrate 11 and semiconductor layers 12 to 15 epitaxially grown thereon.
[FIG. 4] It is a drawing illustrating a reciprocal lattice map of a semiconductor epitaxial substrate 1 composed of a 0° off-angle InP substrate 11 and semiconductor layers 12 to 15 epitaxially grown thereon.
[FIG. 5] It is a drawing illustrating relation of the angle α of the (5-1-1) plane of the InGaAs photo-absorption layer away from the (5-1-1) plane of the InP substrate, with half-value width of reciprocal lattice point of the InGaAs photo-absorption layer.
[FIG. 6] It is a drawing illustrating relation of the angle α of the (5-1-1) plane of the InGaAs photo-absorption layer away from the (5-1-1) plane of the InP substrate, with PL (photoluminescence) intensity which indicates optical quality.

### DESCRIPTION OF THE PREFERRED EMBODIMENTS

Embodiments of the present invention will be explained below, referring to the attached drawings.

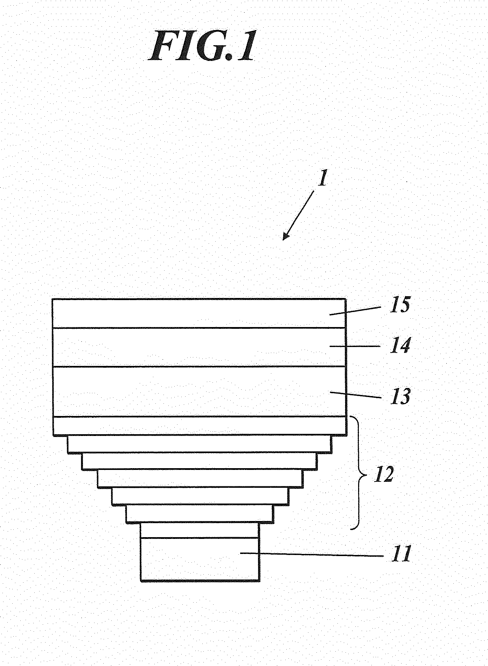

FIG. 1 is a drawing illustrating a multi-layered structure of a semiconductor epitaxial substrate of the present invention applied to a photodiode.
As illustrated in FIG. 1, an semiconductor epitaxial substrate 1 of the embodiment has a multi-layered structure having, stacked in sequence on an InP substrate 11, an InAsP graded buffer layer 12, an InAsP buffer layer 13, an InGaAs photo-absorption layer 14, and an InAsP window layer 15.

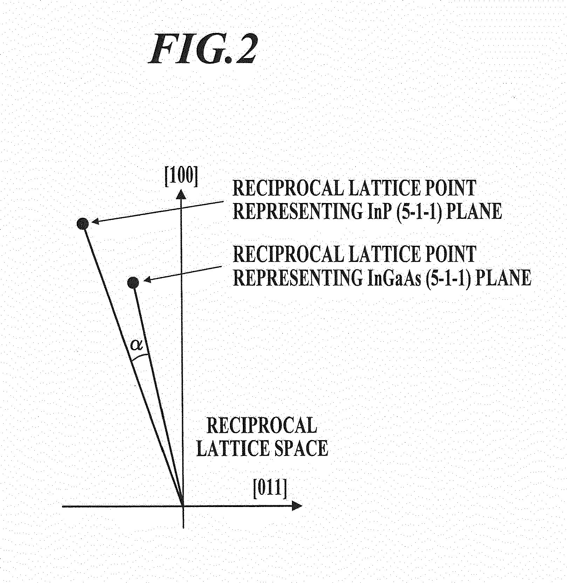

The angle α of the (5-1-1) plane of the InGaAs photo-absorption layer 14 away from the (5-1-1) plane of the InP substrate 11 is set to +0.05° or larger, assuming the clockwise direction of rotation from the [100] direction to the [011] direction as positive. In the following description, the angle formed between the (5-1-1) plane of the InGaAs photo-absorption layer 14 and the (5-1-1) plane of the InP substrate 11 will be depicted similarly, always assuming the clockwise direction of rotation from the [100] direction to the [011] direction as positive.
The angle formed between the (5-1-1) plane of the InGaAs photo-absorption layer 14 and the (5-1-1) plane of the InP substrate 11 is now represented by angle α in the reciprocal lattice space illustrated in FIG. 2. In other words, the angle is calculated by a coordinate of reciprocal lattice point representing the (5-1-1) plane of the InP substrate 1 reciprocal lattice point, and a coordinate of reciprocal lattice point representing the (5-1-1) plane of the InGaAs photo-absorption layer 14.

### [Example]

In Example, the semiconductor epitaxial substrates 1 illustrated in FIG. 1 were manufactured respectively using off-angle InP substrates 11 (lattice constant: 5.8688 Ǻ) having principal surfaces inclined from the (100) plane by 1°, 2°, 3° and 5° into the [110] direction, and the semiconductor layers 12 to 15 with lattice distortion were epitaxially grown in sequence by MOCVD on the InP substrates 11. Source materials of the semiconductor layers 12 to 15 were AsH₃, PH₃, TMIn and TMGa, used under a growth pressure of 50 Torr, at a growth temperature 600 to 670°C.

First, the graded buffer layer 12 composed of a plurality of InAsₓP₁₋ₓ layers was grown on the InP substrate 11. The compositional ratio x of As was adjusted so as to gradually increase the lattice constant. More specifically, by adjusting the compositional ratio x of As to 0.05 to 0.60, the lattice constant of the graded buffer layer 12 was adjusted so as to increase stepwise in the range from 5.8688 Ǻ which is the lattice constant of the InP substrate 11 (first lattice constant), to 5.9852 Ǻ which is the lattice constant of the InGaAs photo-absorption layer 14 (second lattice constant).
Then, the InAsₓP₁₋ₓ buffer layer 13 (lattice constant: 5.9880 Ǻ) having a compositional ratio x of As of approximately 0.6, the In_{y}Ga_{1-y}As photo-absorption layer 14 (lattice constant: 5.9852 Ǻ) having a compositional ratio y of In of approximately 0.82, and the InAsₓP₁₋ₓ window layer 15 having a compositional ratio x of As of approximately 0.6 were grown in sequence on the graded buffer layer 12, to thereby manufacture the semiconductor epitaxial substrate 1.
The InAsP graded buffer layer 12 was approximately 0.3 to 1 µm thick, the InAsP buffer layer 13 was approximately 0.5 to 5 µm thick, the InGaAs photo-absorption layer 14 was 1 to 5 µm thick, and the InAsP window layer 15 was 0.5 to 3 µm thick.

### [Comparative Example]

In Comparative Example, the semiconductor epitaxial substrates 1 illustrated in FIG. 1 were manufactured respectively using off-angle InP substrates 11 (lattice constant: 5.8688 Ǻ) having principal surfaces inclined from the (100) plane by 0° and 0.5° into the [110] direction, and the semiconductor layers 12 to 15 having lattice distortion were epitaxially grown in sequence by MOCVD on each of the InP substrates 11. Specific conditions of the growth were same as those in Example.

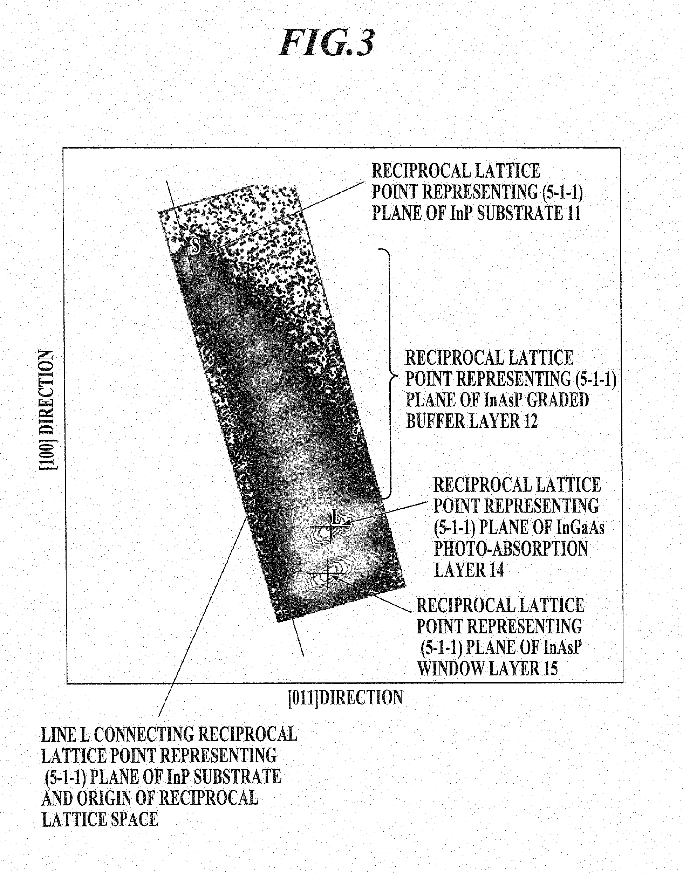

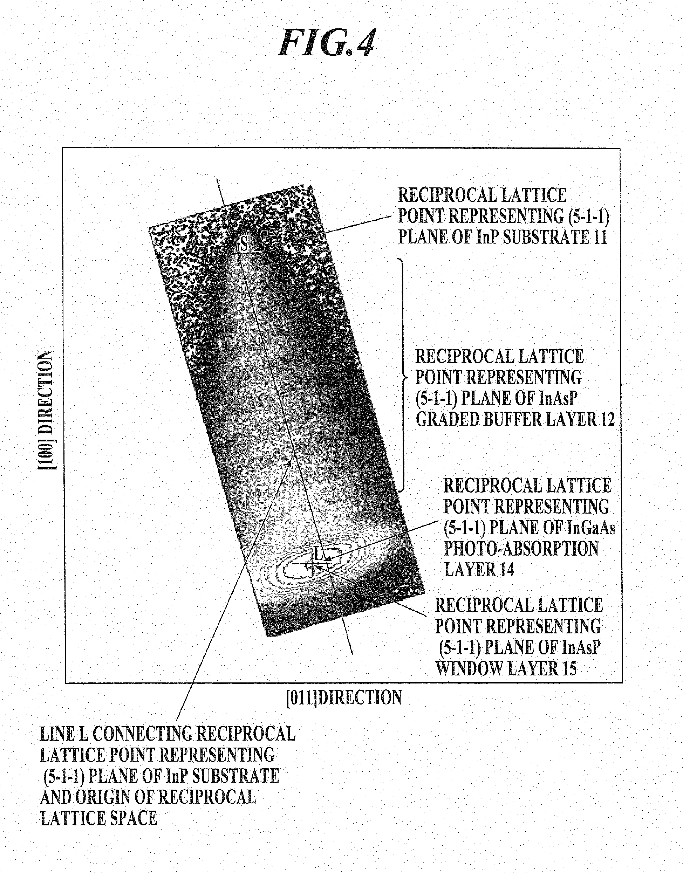

FIG. 3 is a drawing illustrating an exemplary reciprocal lattice map of the (5-1-1) plane of the semiconductor epitaxial substrate 1 manufactured in Example, and FIG. 4 is a drawing illustrating an exemplary reciprocal lattice map of the (5-1-1) plane of the semiconductor epitaxial substrate 1 manufactured in Comparative Example.
FIG. 3 illustrates the reciprocal map of the semiconductor epitaxial substrate 1 having the semiconductor layers 12 to 15 epitaxially grown on the 2° off-angle InP substrate 11, and FIG. 4 illustrates the reciprocal map of the semiconductor epitaxial substrate 1 having the semiconductor layers 12 to 15 epitaxially grown on the 0° off-angle InP substrate 11. In FIGs. 3 and 4, reciprocal lattice vector of the (011) plane is aligned to the direction of X-axis, reciprocal lattice vector of the (100) plane is aligned to the direction of Y-axis, with the same scales for easy comparison of broadening of the reciprocal lattice point.

According to reciprocal lattice mapping, plane spacing of crystal planes and crystal orientation may be determined based on coordinate of the reciprocal lattice point (size of reciprocal lattice vector), and angle formed between different crystal planes may be determined based on coordinates of reciprocal lattice points representing the crystal planes. Degree of crystallinity is also known, since a sample with a poor crystallinity will give a large degree of broadening of the reciprocal lattice points.

In an exemplary reciprocal lattice mapping of the asymmetrical (5-1-1) plane of the semiconductor epitaxial substrate, the coordinate of the reciprocal lattice point gives plane spacing of the (500) plane which is the direction of crystal growth (direction of the normal line on the substrate), plane spacing of the (0-1-1) planes which lie in parallel with the substrate, and angle between the (500) plane and the (0-1-1) plane. From the information including the plane spacing, it is now possible to estimate the degree of lattice relaxation of the grown crystal.
A defect-free ideal crystal will give a reciprocal lattice map showing a circular spot pattern without broadening of the reciprocal lattice point, whereas a mosaic structure which is an assemblage of micro-crystals slightly differing in the direction of orientation will give the reciprocal lattice vectors slightly differing in the direction, and will therefore give a reciprocal lattice map showing an elliptic pattern with a large degree of broadening of the reciprocal lattice point.

It is clearly understood from FIGs. 3 and 4, that the semiconductor epitaxial substrate 1 manufactured in the Example showed a smaller degree of broadening of the reciprocal lattice points in the direction of long axis (lateral direction) as compared with the semiconductor epitaxial substrate 1 manufactured in Comparative Example, proving the improved crystallinity (reduced mosaicity).
Although not illustrated herein, also the semiconductor epitaxial substrates 1 manufactured in Example respectively by using the InP substrates 11 with off-angles of 1°, 3° and 5°, gave similar results with FIG. 3, by which a mosaicity was improved. In contrast, the semiconductor epitaxial substrate 1 manufactured in Comparative Example by using the InP substrate 11 with an off-angle of 0.5°, was found to give a similar result with FIG. 4, indicating deteriorated mosaicity.

This indicates that, when the semiconductor layer (InGaAs photo-absorption layer 14) having the lattice constant larger than that of the growth substrate (InP substrate 11) is grown on the growth substrate, use of a growth substrate with a small off-angle (0° or 0.5°, for example) may induce a mosaic structure having multi-directional crystal orientation in the micro-domains in the grown crystal. On the other hand, use of a growth substrate having an off-angle of certain level or larger (1° or larger, for example) may induce a constant orientation of the grown crystal relative to the growth substrate.

More specifically, when the semiconductor layer having the lattice constant larger than that of the growth substrate is grown on the growth substrate, the crystal grows anyhow up to a critical thickness of the semiconductor layer while deforming the lattice, and upon exceeding the critical thickness, the crystal produces crystal defects and so forth to relax the strain energy.
In this process, the semiconductor layers grown on the growth substrate with an off-angle of 0°, such as in Comparative Example, will produce the micro-domains having the plane direction oriented to all directions, since every direction is energetically equivalent for the crystals in the micro-domains to be aligned, showing a broadened reciprocal lattice point as seen in FIG. 4.
On the other hand, when the growth substrate having an off-angle of 2° was used as in Example, the broadening of the reciprocal lattice point will reduce as seen in FIG. 3. In short, it is understood that the use of the growth substrate with an off-angle of 2° allows the growth in a constant direction, whereas the use of the growth substrate with an off-angle of 0° results in the mosaic structure due to growth of crystal in all directions.

What is worthy of mention is that, while the semiconductor epitaxial substrate 1 of Comparative Example shows the individual reciprocal lattice points representing the (5-1-1) planes of the semiconductor layers 12 to 15 fallen on line L which connects the reciprocal lattice point representing the (5-1-1) plane of the InP substrate 11 and the origin of the reciprocal lattice space (see FIG. 4), whereas the semiconductor epitaxial substrate 1 of Example shows the individual reciprocal lattice points representing the (5-1-1) planes of the semiconductor layers 12 to 15 fallen slightly away from line L (see FIG. 3).
Our analytical study revealed that the semiconductor epitaxial substrate 1 of Comparative Example showed an angle between the (5-1-1) plane of the InGaAs photo-absorption layer 14 and the (5-1-1) plane of the InP substrate 11 of -0.07 to +0.03°, whereas the semiconductor epitaxial substrate 1 of Example showed the angle of +0.05 to +0.72°.

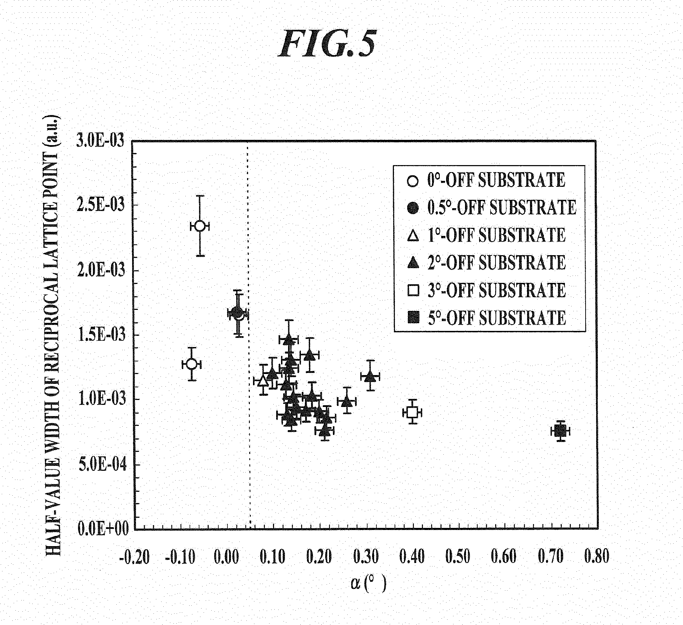

FIG. 5 is a drawing illustrating relation of the angle α of the (5-1-1) plane of the InGaAs photo-absorption layer 14 away from the (5-1-1) plane of the InP substrate 11, with half-value width of reciprocal lattice point of the InGaAs photo-absorption layer 14, in the semiconductor epitaxial substrates 1 manufactured in Example and Comparative Example.
As illustrated in FIG. 5, the half-value width reduces as the angle α increases. In particular, the half-value width is smaller than 1.5×10⁻³ a.u. if the angle α is set to 0.05° or larger, proving an extremely good crystallinity.

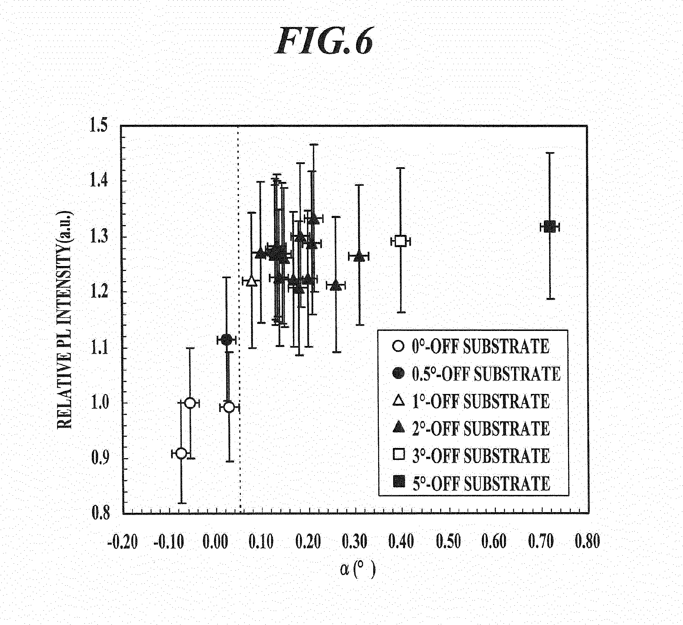

FIG. 6 is a drawing illustrating relation of the angle α of the (5-1-1) plane of the InGaAs photo-absorption layer 14 away from the (5-1-1) plane of the InP substrate 11, with PL intensity which indicates optical quality.
As illustrated in FIG. 6, the PL intensity increases by 20 to 30% when the angle α is set to 0.05° or larger, as compared with the case with an angle α of 0.05° or smaller, proving formation of high-quality semiconductor layers also from the viewpoint of optical quality.

In short, it is understood that, in the semiconductor epitaxial substrate having an angle between the (5-1-1) plane of the InGaAs photo-absorption layer 14 and the (5-1-1) plane of the InP substrate 11 of +0.05° or larger, assuming the clockwise direction of rotation from the [100] direction to the [011] direction as positive, the InGaAs photo-absorption layer 14 grows while being aligned in a constant direction, to thereby give a high-quality crystal with only a small mosaicity. Accordingly, by using the semiconductor epitaxial substrate 1, performances of semiconductor devices such as infrared sensors may be improved.

Note that the angle between the (5-1-1) plane of the InGaAs photo-absorption layer 14 and the (5-1-1) plane of the InP substrate 11 is most largely affected by the off-angle of the InP substrate 11, but not solely. Use of the off-angle substrate as the growth substrate is merely one technique of adjusting the angle between the (5-1-1) plane of the InGaAs photo-absorption layer 14 and the (5-1-1) plane of the InP substrate 11 to 0.05° or larger, and use of the InP substrate 11 having an off-angle of 1° or larger, for example, is supposed to be preferable.

Having described the present invention conceived by the present inventors referring to the specific embodiment, the present invention is not limited thereto, and may be modified without departing from the spirit thereof.
The embodiment described in the above dealt with the case where the InGaAs layer 14 was grown over the InP substrate 11, while placing the InAsP graded buffer layer 12 and the InAsP buffer layer 13 in between, the present invention is also applicable to a semiconductor epitaxial substrate which includes, epitaxially grown on a semiconductor substrate having a first lattice constant, a graded buffer layer which is compositionally graded so as to increase the lattice constant stepwise in the range from the first lattice constant to a second lattice constant larger than the first lattice constant; and a semiconductor layer which is composed of a semiconductor crystal having the second lattice constant.
For example, the present invention is applicable to a semiconductor epitaxial substrate which includes, grown on a Si substrate, a SiₓGe₁₋ₓ graded buffer layer and a SiₓGe₁₋ₓ layer which have the lattice constant larger than that of Si, or a semiconductor epitaxial substrate which includes, grown on a GaAs substrate, an InₓAl₁₋ₓAs compositionally graded buffer layer and an InₓAl₁₋ₓAs layer which have the lattice constant larger than that of Ga.

The embodiment described in the above dealt with the case where the angle between the (5-1-1) plane of the InGaAs photo-absorption layer 14 and the (5-1-1) plane of the InP substrate 11 is 0.05° or larger, our crystallographic investigations also revealed that the same will apply to the asymmetric (mnn) planes (m and n are integers, where 0≤m, n≤7, except m=n=0), such as the (311) plane, the (511) plane, and the (711) plane.
In short, the semiconductor epitaxial substrate of the present invention characteristically has an angle, between the (mnn) plane (where, m and n are integers except m=n=0) of the semiconductor layer and the (mnn) plane of the semiconductor substrate, of +0.05° or larger, assuming the clockwise direction of rotation from the [100] direction to the [011] direction as positive.

It is to be understood that the embodiment disclosed in the above is illustrative but not restrictive in all aspects. The scope of the present invention is to be determined solely by the claims rather than by the description, so that all changes that fall within metes and bounds of the claims, or equivalence thereof are therefore intended to be embraced therein.

### Explanation of the Marks

1 semiconductor epitaxial substrate
11 InP substrate (semiconductor substrate with first lattice constant)
12 InAsP graded buffer layer
13 InAsP buffer layer
14 InGaAs photo-absorption layer (semiconductor layer with second lattice constant)
15 InAsP window layer

## Claims

1. A semiconductor epitaxial substrate comprising:
a semiconductor substrate having a first lattice constant;
a graded buffer layer which is compositionally graded so as to increase the lattice constant stepwise in the range from the first lattice constant to a second lattice constant larger than the first lattice constant and epitaxially grown on the semiconductor substrate; and
a semiconductor layer which is composed of a semiconductor crystal having the second lattice constant and epitaxially grown on the graded buffer layer, wherein
the angle between the (mnn) plane (where, m and n are integers except m=n=0) of the semiconductor layer and the (mnn) plane of the semiconductor substrate is +0.05° or larger, when the clockwise direction of rotation from the [100] direction to the [011] direction is positive.

2. The semiconductor epitaxial substrate of Claim 1,
wherein
the semiconductor substrate is composed of InP;
the graded buffer layer is composed of InAsP; and
the semiconductor layer is composed of InGaAs.
